(19) Europäisches Patentamt / European Patent Office / Office européen des brevets

(11) **EP 1 825 536 B1**

(12) **FASCICULE DE BREVET EUROPEEN**

(45) Date de publication et mention de la délivrance du brevet:
**19.10.2011 Bulletin 2011/42**

(21) Numéro de dépôt: **05850435.8**

(22) Date de dépôt: **05.12.2005**

(51) Int Cl.:
*H01L 51/52* (2006.01)

(86) Numéro de dépôt international:
**PCT/EP2005/056465**

(87) Numéro de publication internationale:
**WO 2006/061363 (15.06.2006 Gazette 2006/24)**

(54) **DIODE ORGANIQUE ELECTROLUMINESCENTE ET PANNEAU DE DIODES A COUCHE ANTI-REFLET FAVORISANT L'EXTRACTION DE LUMIERE**

ORGANISCHE ELEKTROLUMINESZENZDIODE UND DIODENTAFEL MIT ZUR EMISSION VON LICHT LEITFÄHIGER ANTIREFLEXIONSBESCHICHTUNG

ORGANIC ELECTROLUMINESCENT DIODE AND DIODE PANEL WITH ANTI-REFLECTIVE COATING CONDUCIVE TO THE EMISSION OF LIGHT

(84) Etats contractants désignés:
**DE FR GB**

(30) Priorité: **07.12.2004 FR 0452891**

(43) Date de publication de la demande:
**29.08.2007 Bulletin 2007/35**

(73) Titulaire: **Thomson Licensing**
**92130 Issy-les-Moulineaux (FR)**

(72) Inventeurs:
- **HAAS, Gunther**
  **F-35760 Saint Grégoire (FR)**
- **FERY, Christophe**
  **78078 Niedereschach (DE)**

(74) Mandataire: **Browaeys, Jean-Philippe**
**Technicolor**
**1-5 rue Jeanne d'Arc**
**92130 Issy-les-Moulineaux (FR)**

(56) Documents cités:
EP-A- 1 154 676      WO-A-2004/044998
US-A1- 2003 173 891      US-A1- 2004 178 722

- **CHIH-JEN YANG ET AL: "High-contrast top-emitting OLEDs for OLED displays" LASERS AND ELECTRO-OPTICS SOCIETY, 2004. LEOS 2004. THE 17TH ANNUAL MEETING OF THE IEEE RIO GRANDE, PUERTO RICO NOV. 8-9, 2004, PISCATAWAY, NJ, USA,IEEE, vol. 1, 8 novembre 2004 (2004-11-08), pages 186-187, XP010748875 ISBN: 0-7803-8557-8**
- **PATENT ABSTRACTS OF JAPAN vol. 2003, no. 12, 5 décembre 2003 (2003-12-05) -& JP 2003 303685 A (CANON INC), 24 octobre 2003 (2003-10-24)**
- **PATENT ABSTRACTS OF JAPAN vol. 2002, no. 04, 4 août 2002 (2002-08-04) -& JP 2001 338770 A (TOHOKU PIONEER CORP), 7 décembre 2001 (2001-12-07)**

**EP 1 825 536 B1**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

L'invention concerne une diode organique électroluminescente susceptible d'émettre de la lumière, comprenant :

- un substrat,
- une couche organique électroluminescente intercalée entre une électrode inférieure et une électrode supérieure partiellement transparente comprenant une sous-couche conductrice transparente qui est continue et d'épaisseur homogène et une sous-couche métallique opaque de répartition du courant qui présente des fenêtres pour le passage de la lumière émise par la couche électroluminescente,
- et une couche diélectrique transparente anti -reflet en contact, par sa face externe, avec un milieu, généralement de l'air, et, par sa face interne, avec ladite sous-couche conductrice transparente et ladite sous -couche métallique opaque.

Il s'agit donc d'une diode dite à émission vers le haut (c'est à dire émettant à l'opposé du substrat). De telles diodes peuvent être à structure classique, auquel cas l'électrode supérieure est une cathode, ou à structure dite inverse, auquel cas l'électrode supérieure est une anode.

L'électrode supérieure de cette diode est donc au moins bi -couche : une sous-couche principale conductrice transparente assure une répartition homogène des charges électriques vers la couche électroluminescente, de manière à créer un champ électrique uniforme dans l'épaisseur de cette couche, et une sous -couche opaque de répartition du courant, par exemple une grille métallique qui sert essentiellement à renforcer la conductivité de l'électrode supérieure et entre les barreaux de laquelle la lumière émise dans la couche électroluminescente peut passer.

L'invention concerne également les réseaux de ces diodes, notamment ceux qui forment des panneaux d'éclairage ou d'affichage, notamment d'images.

La réflexion de la lumière ambiante sur la sous -couche opaque de répartition du courant, par exemple sur les barreaux de la grille précédemment citée, dégrade fortement le contraste d'émission de la diode en lumière ambiante. L'application d'une couche anti-reflet d'épaisseur homogène, c'est à dire en « pleine couche », sur l'ensemble de la surface active de la diode permet de résoudre ce problème mais cette couche anti-reflet risque alors de dégrader la transparence globale de l'électrode supérieure et, par conséquent, le rendement lumineux de la diode

Le document US 2004/0178722 décrit une dispositive organique électroluminescent comportant une couche métallique opaque de répartition de courant sur laquelle une couche anti-reflet est déposée afin de limiter les réflexions de la lumière ambiante sur cette couche.

Le document Yang et Al., "High contrast top emitting OLEDs for OLED displays" Lasers and Electo-optics society, 2004, the 17th annual meeting of the IEEE Rio Grande, nov. 8-9, 2004, vol. 1, 8 novembre 2004, pages 186-187, décrit une diode à émission vers le haut dans laquelle la réflexion de la lumière ambiante sur l'électrode inférieure réfléchissante est réduite et l'extraction à travers la cathode semi-transparente est optimisée par l'utilisation d'un film anti-reflet.

Un but de l'invention est d'apporter un compromis optimum entre la fonction anti-reflet d'une telle couche au niveau des zones opaques de l'électrode supérieure et les propriétés optiques globales de l'électrode supérieure de manière à garantir les meilleures performances d'extraction de la lumière émise par la diode au travers de cette électrode.

A cet effet, l'invention a pour objet une diode organique électroluminescente susceptible d'émettre de la lumière, telle que definie dans la revendication 1.

Grâce à la couche inférieure réfléchissante, on améliore sensiblement l'extraction de lumière émise et le rendement lumineux de la diode.

De préférence, cette couche inférieure réfléchissante est formée par ou partie intégrante de électrode inférieure ; elle est alors généralement métallique et opaque.

Selon d'autres variantes possibles :

- cette couche inférieure réfléchissante est intercalée entre le substrat et l'électrode inférieure, qui est alors transparente ou sem i-transparente ;
- cette couche inférieure réfléchissante est intercalée entre l'électrode inférieure et la couche organique électroluminescente ;
- cette couche inférieure réfléchissante est partie intégrante du substrat ; dans le cas d'un substrat formé par une matrice active, la couche inférieure réfléchissante peut être formée par l'une des couches de la matrice active.

Cette couche inférieure réfléchissante peut être en matériau diélectrique, et présenter une structure multicouche (réflecteur de Bragg).

La sous-couche métallique de répartition du courant se présente de préférence sous la forme d'une grille dont les barreaux présentent une épaisseur suffisamment importante pour améliorer sensiblement la distribution du courant tout en ménageant, entre c es barreaux, des fenêtres suffisamment larges pour le passage de la lumière émise par la couche électroluminescente. La lumière qui est émise par la couche électroluminescente en direction des zones opaques, notamment les barreaux, de la sous-couche métallique de répartition du courant, est en général réfléchie par ces zones opaques vers l'intérieur de la diode. L'électrode supérieure est donc partiellement transparente, notamment à cause des zones opaques de la sous -couche métallique de répartition du courant.

La sous-couche métallique de répartition du courant est directement déposée sur une sous-couche conductrice transparente, parmi l'une ou la pluralité de sous - couches conductrices transparentes ou semi-transparentes. La sous-couche conductrice transparente sur laquelle est directement déposée la sous-couche de répartition du courant est généralement à base d'oxyde semi conducteur comme l'ITO (« Indium Tin Oxide »). On peut également utiliser un métal comme l'argent pour cette sous-couche conductrice transparente, auquel cas son épaisseur est très faible pour conférer le caractère transparent, ou, au moins, semi-transparent. On peut également utiliser deux sous-couches conductrices transparentes déposées l'une sur l'autre : une sous-couche à base d'argent, puis une sous - couche à base d'ITO. L'au moins une sous -couche conductrice transparente ou semi-transparente recouvre l'ensemble de la surface active de la diode et ne présente normalement pas de trous. Son épaisseur est généralement constante sur l'ensemble de la surface active de la diode.

La lumière émise par la couche électroluminescente traverse l'électrode supérieure par les fenêtres ou trous ménagés entre les zones opaques de la sous - couche métallique de répartition du courant. La conductivité surfacique de cette sous-couche métallique est, à l'endroit de ces zones opaques, comme par exemple à l'endroit des barreaux de la grille précédemment citée, de préférence au moins 10 fois supérieure à celle d'au moins une sous-couche conductrice transparente sous-jacente, de manière à assurer efficacement la répartition du courant circulant dans l'électrode supérieure.

La couche diélectrique transparente anti -reflet est directement déposée sur une sous -couche métallique de répartition du courant précédemment citée ; elle est donc en contact, par sa face interne, d'une part avec la sous -couche métallique de répartition du courant à l'end roit des zones opaques, d'autre part avec cette sous-couche conductrice transparente au travers des fenêtres de l a sous-couche de répartition. Selon l'invention, du fait du revêtement des zones opaques par cette couche anti-reflet, la réflectance de la lumière ambiante à l'endroit de ces zones opaques est inférieure à 0,1 ; plus précisément, cette réflectance est mesurée en incidence normale à une longueur d'onde $\lambda_{amb}$ proche de 550 nm. La valeur de la longueur d'onde $\lambda_{amb}$ correspond à la longueur d'onde approximative du maximum d'émittance de la lumière ambiante, en tenant compte de la sensibilité spectrale de l'oeil humain.

Selon l'invention, la couche diélectrique transparente apporte donc, comme **première fonction,** un effet anti-reflet optimal pour la lumière ambiante vis-à-vis de la surface, réfléchissante, de la sous-couche conductrice opaque de répartition du courant. On améliore donc le contraste d'émission de la diode en lumière ambiante.

De préférence, si $n_1$ est l'indice optique dudit milieu à la longueur d'onde $\lambda_{amb}$, le matériau d'indice $n_2(\lambda_{amb})$ mesuré à la longueur d'onde $\lambda_{amb}$, et l'épaisseur $d_2$ de ladite couche diélectrique anti -reflet sont choisis avec le matériau d'indice $\tilde{n}_3$ de ladite sous-couche métallique de répartition du courant, qui est mesuré à la même longueur d'onde $\lambda_{amb}$ et qui est défini par son argument $n_3$ et sa phase $\Phi$ de sorte que $\tilde{n}_3 = n_3 e^{i\Phi}$, de manière à satisfaire approximativement la relation :

$$n_2(\lambda_{amb}) = \frac{\sqrt{-(n_1\cos(\phi) - n_3 + n_3\sin^2(\phi))n_3 n_1(n_1\sin^2(\phi) + n_3\cos(\phi) - n_1)}}{-(n_1\sin^2(\phi) + n_3\cos(\phi) - n_1)}$$

Grâce aux choix des matériaux notamment de la couche anti -reflet et de la couche de répartition du courant, on obtient alors une réflectivité faible ou très faible de la lumière ambiante sur les zones opaque de l'électrode supérieure, ce qui améliore sensiblement le contraste d'émission de la diode en lumière ambiante.

En outre, et pour compléter la fonction anti -reflet, de préférence, le matériau d'indice $n_2(\lambda_{amb})$ mesuré à une longueur d'onde $\lambda_{amb}$ proche de 550 nm, et l'épaisseur $d_2$ de ladite couche diélectrique anti -reflet sont choisis de manière à satisfaire approximativement la relation :

$$d_2 = \frac{\lambda_{amb}}{4n_2(\lambda_{amb})}\left(p - \frac{\phi_{2-3}}{\pi}\right)$$

où p est un entier pair quelconque, où $\Phi_{2-3}$ est le déphasage d'un rayon de lumière de longueur d'onde $\lambda_{amb}$ après

réflexion à l'interface entre la couche diélectrique anti-reflet et la sous-couche métallique de répartition du courant.

L'équation donnant la valeur de $d_2$ exprime ici des interférences destructrices de la lumière ambiante au sein de la couche diélectrique anti -reflet.

Grâce à cette épaisseur de la couche anti-reflet, on obtient alors une réflectivité faible ou très faible de la lumière ambiante sur l'électrode supérieure, ce qui améliore encore le contraste d'émission de la diode en lumière ambiante.

De préférence, le matériau de ladite couche diélectrique anti -reflet et le matériau de ladite sous-couche métallique de répartition du courant, sont respectivement :

- soit le nitrure de silicium et le tantale,
- soit l'oxyde de titane et l'un parmi le nickel, le chrome, le titane ou le va nadium.
- soit le séléniure de zinc et l'un parmi le nickel, le chrome, le titane ou le vanadium.

La couche diélectrique anti-reflet et l'au moins une sous-couche conductrice transparente composent une couche supérieure semi -réfléchissante adaptée pour réfléchir partiellement ladite lumière émise par la couche électroluminescente. La couche inférieure réfléchissante et cette couche supérieure semi-réfléchissante ainsi composée délimitent ainsi une cavité optique. Le matériau et l'épaisseur de ladite couche diélectrique anti -reflet sont choisis avec le matériau et l'épaisseur de la sous-couche conductrice transparente de manière à ce que la couche supérieure semi-réfléchissante réfléchisse partiellement la lumière émise.

Ainsi, la diode comprend une couche supérieure semi -réfléchissante adaptée pour réfléchir partiellement ladite lumière émise, qui est , au moins partiellement, intégrée à l'électrode supérieure. Selon l'invention, la couche diélectrique transparente, qui appartient à cette couche supérieure semi-réfléchissante, apporte donc, comme **deuxième fonction,** un effet d'optimisation du caractère semi-réfléchissant de cette couche supérieure semi-réfléchissante. La même couche diélectrique transparente, d'épaisseur approximativement homogène, donc déposée avantageusement sans masque, sert donc à la fois de couche anti -reflet et de couche améliorant la réflectivité de l'une des parois de la cavité optique.

L'électrode supérieure peut également comprendre une sous -couche d'injection de charges, intercalée entre la couche organique électroluminescente et la sous-couche conductrice transparente, qui peut également faire partie de la couche supérieure semi-réfléchissante.

Si l'électrode supérieure est une cathode, on peut choisir un métal à faible fonction de travail, comme le calcium; on peut également utiliser un mélange du type LiF + Al ; si l'électrode supérieure est une anode, on peut choisir un métal à fonction de travail élevée, comme l'argent ou l'or.

L'électrode supérieure pe ut comprendre une deuxième sous-couche conductrice semi-transparente, qui peut notamment servir de barrière de diffusion lorsqu'elle est intercalée entre la couche organique électroluminescente et l'autre sous-couche conductrice transparente ; cette deuxième sous-couche conductrice semi-transparente est alors également destinée à empêcher la diffusion de composants de l'électrode supérieure dans la couche organique électroluminescente, de manière à en empêcher la dégradation ; de préférence, on utilise l'argent pour cette sous-couche.

La couche inférieure réfléchissante et la couche supérieure semi-réfléchissante délimitant une cavité optique pour la lumière émise par la couche organique électroluminescente, la distance $d_6$ entre ces couches délimitant cette cavité est de préférence adaptée pour obtenir des interférences constructives de la lumière émise au sein de cette cavité. Ces interférences constructives favorisent avantageusement l'extraction de la lumière émise au travers de l'électrode supérieure, ce qui améliore le rendement lumineux de la diode.

De préférence, ladite distance $d_6$ satisfait alors approximativement la relation suivante :

$$d_6 = \frac{\lambda}{2n_6}\left(q - \frac{\phi_{tot}}{2\pi}\right)$$

- où q est un entier quelconque,
- où $\lambda$, est une longueur d'onde proche d'un maximum d'émittance de la lumière émise, et $n_6$ est l'indice moyen de la couche organique électroluminescente à cette longueur d'onde $\lambda$,
- et où $\phi_{tot}$ est le déphasage total d'un rayon de lumière émise, après réflexion par la couche inférieure réfléchissante et par la couche supérieure semi -réfléchissante.

En ce qui concerne la couche supérieure semi-réfléchissante, l'indice $n_2$ mesuré à la longueur d'onde $\lambda^*$ et l'épaisseur $d_2$ de ladite couche diélectrique anti-reflet, l'indice $n_4$ mesuré à la longueur d'onde $\lambda$ et l'épaisseur $d_4$ d'une première sous-couche conductrice transparente, et, le cas échéant, l'indice $n_5$ mesuré à la longueur d'onde $\lambda$ et l'épaisseur $d_5$ d'une deuxième sous-couche conductrice transparente sont choisis en combinaison de manière à ce que la **réflec-**

**tance** de l'empilement desdites couches et sous -couche, mesurée à cette longueur d'onde λ en incidence normale, soit **maximum**. On aboutit avantageusement au meilleur compromis entre la transparence et la réflectivité de cet empilement, qui concourent toutes les deux au meilleur rendement lumineux de la diode.

Selon une autre variante concernant la couche supérieure semi - réfléchissante, cette couche peut comprendre une structure diélectrique multicouche (réflecteur de Bragg) telle que décrite dans le document US2003 - 184982 qui est déposée sur l'électrode supérieure. Cette structure multicouche peut servir à l'encapsulation de la diode, comme illustré dans le document W003 - 052842.

En augmentant ainsi l'effet de cavité optique, on renforce encore les interférences constructives dans cette cavité et on améliore l'extraction de ia lumière émise et le rendement lumineux de la diode.

En pratique, ayant choisi le matériau de la sous -couche conductrice transparente en fonction de critères de conductivité et de transparence, le matériau et l'épaisseur de la couche supérieure semi-réfléchissante en fonction de critères de performances d'injection de charges et de barrière de diffusion dans la couche organique électroluminescente, on détermine l'épaisseur de la sous-couche conductrice transparente de manière à obtenir le maximum de réflectivité, en incidence normale, de la lumière émise dans la couche organique électroluminescente sur l'interface avec la couche supérieure semi-réfléchissante.

De préférence, ladite couche inférieure réfléchissante est à l'interface entre ladite électrode inférieure et ladite couche organique électroluminescente et en ce que ladite couche supérieure semi -réfléchissante est à l'interface entre ladite électrode supérieure et ladite couche organique électroluminescente.

Dans ce cas, chaque électrode a une fonction réfléchissante.

La distance $d_6$ correspond alors à l'épaisseur de la couche organique électroluminescente entre les électrodes ; l'équation fixant ci-dessus la valeur approximative de $d_6$ exprime des interférences constructives de la lumière émise dans la cavité optique délimitée ici par l'électrode inférieure et par l'électrode supérieure.

De préférence, la distance séparant la couche organique électroluminescente de la couche inférieure réfléchissante est adaptée pour obtenir des interférences constructives entre ladite lumière émise et la lumière réfléchie sur cette couche inférieure réfléchissante.

De préférence, ladite couche organique électroluminescente comprend alors une sous-couche organique émissive et au moins une sous -couche organique inférieure non -émissive qui est intercalée entre ladite couche inférieure réfléchissante et ladite sous -couche émissive, et l'épaisseur de la ou des sous - couches organiques inférieures non -émissives est/sont adaptée(s) pour que la distance z séparant le centre de ladite sous -couche organique émissive de ladite couche inférieure réfléchissante satisfasse approximativement la relation :

$$z = \frac{\lambda}{2n_6}\left(r - \frac{\phi_{\text{inf}}}{2\pi}\right)$$

- r est un entier quelconque ;
- où λ est ladite longueur d'onde λ proche d'un maximum d'émittance de la lumière émise, et $n_6$ est l'indice moyen de la couche organique électroluminescente à cette longueur d'onde,
- où $\phi_{\text{int}}$ est le déphasage d'un rayon de lumière émise, après réflexion par la couche inférieure réfléchissante .

Le centre de la sous-couche organique émissive correspond à un niveau dans cette sous-couche approximativement équidistant de la face inférieure et de la face supérieure de cette sous -couche.

Généralement, la ou les sous -couches organiques inférieures non émissives sont adaptées pour l'injection et/ou le transport de porteurs d'un premier genre; la couche organique électroluminescente comprend alors de préférence également au moins une sous-couche organique supérieure non -émissive qui est intercalée entre l'électrode supérieure et ladite sous-couche émissive, et qui est de préférence adaptée pour l'injection et/ou le transport de porteurs d'un second genre. Les genres de porteur correspondent à électron et trou

L'invention a également pour objet un panneau de visualisation d'images ou d'éclairage comprenant une pluralité de diodes selon l'une quelconque des revendications précédentes caractérisé en ce que ces diodes sont supportées par le même substrat.

De préférence, l'électrode supérieure est alors commune à la pluralité de ces diodes. La sous-couche conductrice transparente de cette électrode s'étend alors sur l'ensemble de la surface active du panneau.

De préférence, la sous-couche conductrice opaque de l'électrode supérieure commune forme une grille de répartition du courant sur cette électrode.

En résumé des principales caractéristiques ci dessus, l'invention a pour objet une diode organique électroluminescente et un panneau comprenant un réseau de ces diodes ; cette diode comprend une couche organique électroluminescente, intercalée entre une électrode inférieure et une électrode supérieure partiellement transparente et semi-réfléchissante, qui comprend elle-même une sous-couche conductrice transparente et une sous -couche métallique de répartition du courant, par exemple une grille opaque ; une couche diélectrique anti -reflet est déposée sur la grille pour améliorer le contraste d'émission en lumière ambiante, qui, selon une variante avantageuse, est adaptée pour optimiser les propriétés semi - réfléchissante de l'électrode supérieure, ce qui permet d'améliorer par effet de cavité optique, l'extraction de lumière émise.

L'invention sera mieux comprise à la lecture de la description qui va suivre, donnée à titre d'exemple non limitatif, et en référence aux figures annexées sur lesquelles :

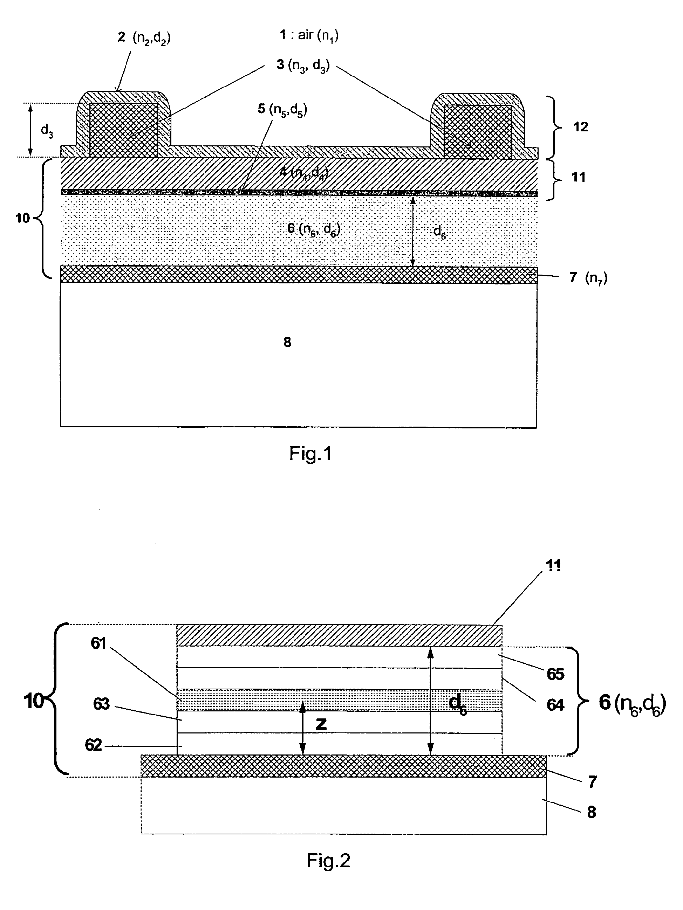

- la figure 1 est une coupe schématique de l'ensemble d'une diode selon un premier mode de réalisation de l'invention,
- la figure 2 est une coupe détaillée de l'empilement des sous -couches organiques de la diode selon la figure 1, entre l'électrode inférieure et l'électrode supérieure.

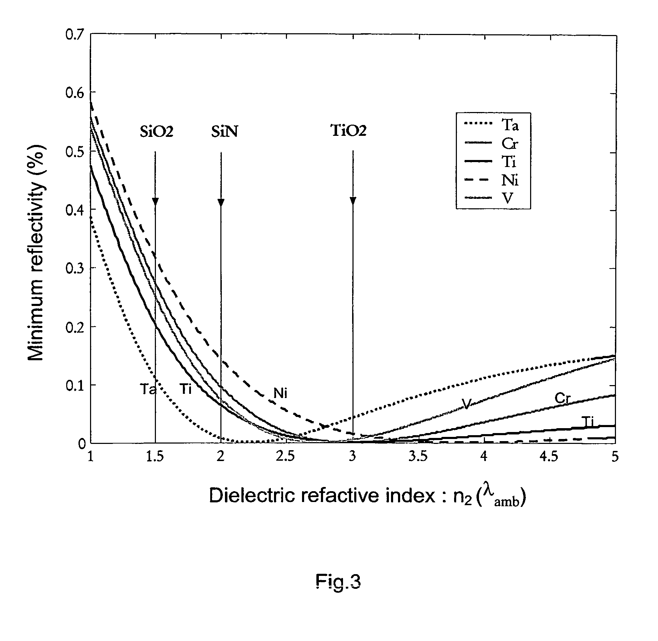

- la figure 3 décrit l'évolution du minimum de réflectivité d'un métal en fonction de l'indice « théorique » du matériau d'une couche diélectrique recouvrant ce métal pour assurer une fonction anti -reflet : chaque courbe illustre cette évolution pour un métal différent : Ta, Cr, Ti, Ni et V.

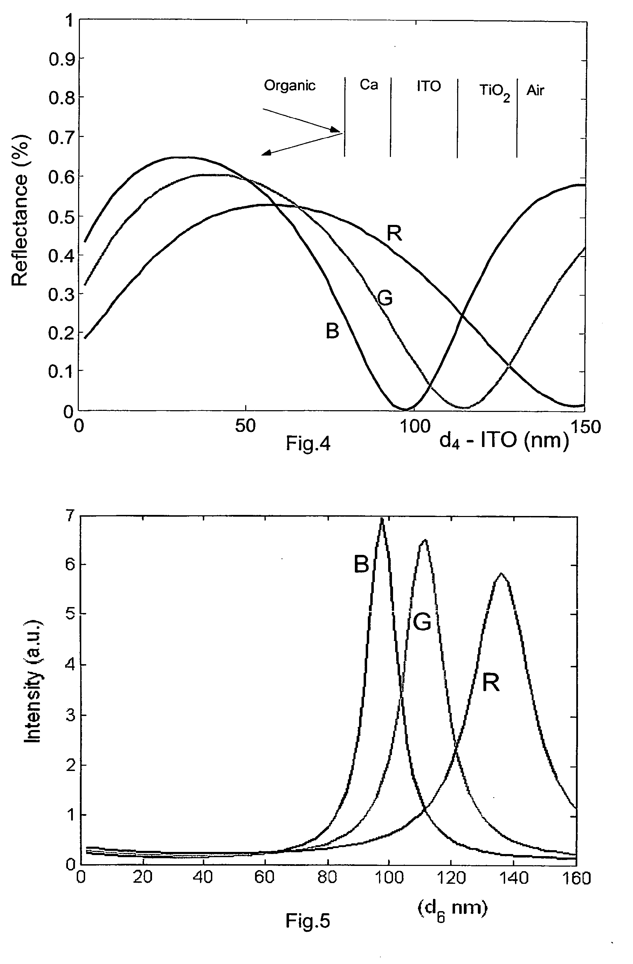

- la figure 4 représente la variation de la réflectance d'un empilement d'une sous - couche de 15 nm de calcium, d'une sous -couche d'ITO d'épaisseur $d_4$ et d'une couche diélectrique de 27 nm d'oxyde de titane en fonction de l'épaisseur $d_4$ de la couche d'ITO (en nm) uti lisées en couches ou sous -couches supérieures dans la diode selon le premier mode de réalisation ; chaque courbe illustre cette variation pour une longueur d'onde différente : 636 nm pour la courbe R, 516 nm pour la courbe G et 452 nm pour la courbe B ;
- la figure 5 représente la variation de l'intensité lumineuse (unités arbitraires) de la diode selon le premier mode de réalisation en fonction de la valeur de l'épaisseur $d_6$ (nm) de la couche organique de cette diode; chaque courbe illustre cette variation pour une couleur d'émission différente; rouge pour la courbe R, verte pour la courbe G et bleue pour la courbe B ;

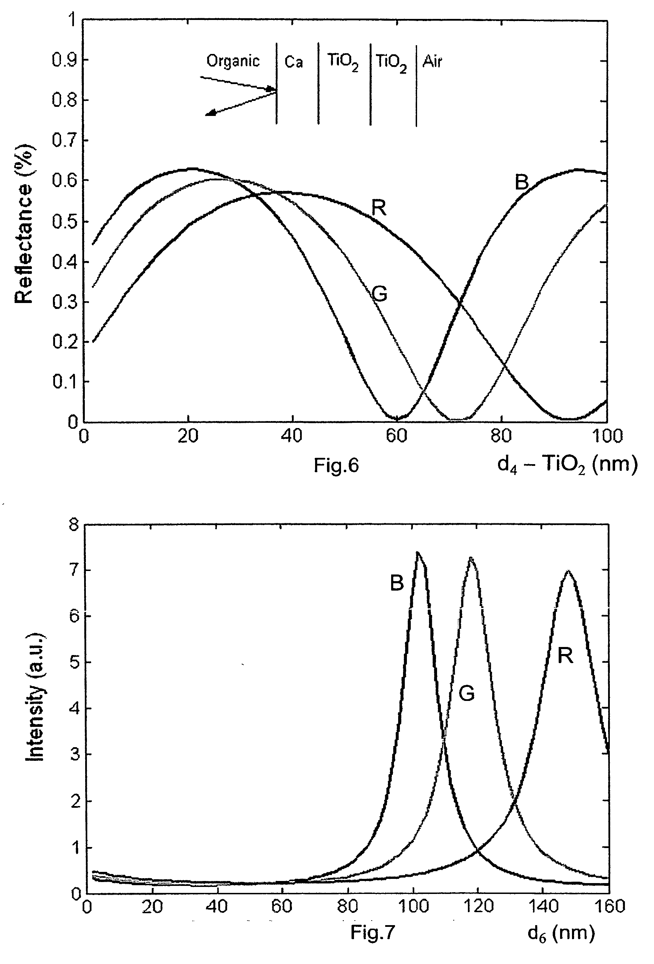

- la figure 6 représente la variation de la réflectance d'un empilement d'une sous - couche de 15 nm de calcium, d'une sous -couche d'oxyde de titane d'épaisseur $d_4$ et d'une couche diélectrique de 27 nm d'oxyde de titane en fonction de l'épaisseur $d_4$ de la sous-couche d'oxyde de titane (en nm) utilisées en couches ou sous - couches supérieures dans la diode selon un deuxième mode de réalisation d e l'invention ; chaque courbe illustre cette variation pour une longueur d'onde différente : 636 nm pour la courbe R, 516 nm pour la courbe G et 452 nm pour la courbe B ;
- la figure 7 représente la variation de l'intensité lumineuse (unités arbitraires) de la diode selon le deuxième mode de réalisation en fonction de la valeur de l'épaisseur $d_6$ (nm) de la couche organique de cette diode; chaque courbe illustre cette variation pour une couleur d'émission différente: rouge pour la courbe R, verte pour la courbe G et bleue pour la courbe B ;

On va maintenant décrire un **premier mode de réalisation** d'une diode ou d'un réseau de diodes selon l'invention, avec quelques variantes non limitatives, ainsi que quelques étapes de sa fabrication, en se référant notamment aux figures 1 et 2.

On part d'un substrat 8, par exemple une plaque de verre ou une matrice active comprenant des circuits de commande de diode. Ce substrat est doté d'une électrode ou d'un réseau d'électrodes inférieures métalliques réfléchissantes 7 destinées à servir de cathodes, chaque électrode inférieure étant reliée à une sortie d'un circuit de commande du substrat. La couche inférieure d'électrode(s) inférieure(s) est ici en aluminium ou en chrome. Son épaisseur est d'environ 0,1 $\mu$m.

Sur cette couche inférieure d'électrode(s) réfléchissante(s) 7, on dépose d'une manière connue en elle-même une couche organique électroluminescente 6 formée de l'empilement suivant, décrit à la figure 2 :

- une sous-couche 62 de 4,7-diphenyl-1,10-phenanthroline (BPhe n) dopée au césium pour l'injection et le transport d'électrons, d'épaisseur $d_{62}$ déterminée ultérieurement:
- une sous-couche 63 de 4,7-diphenyl-1,10-phenanthroline (BPhen) non dopé d'environ d'épaisseur $d_{63}$ = 10 nm, pour le blocage des trous ;
- une sous-couche émissive 61 d'épaisseur $d_{61}$ = 20 nm, adaptée pour émettre de la lumière lorsqu'elle est traversée par un courant, par exemple de la lumière rouge, verte, bleue ou blanche ; l'émittance de cette sous -couche présente un maximum pour une longueur d'onde $\lambda$ ;
- une sous-couche 64 de spiro-bifluorène de 2,2',7,7'- tetrakis(N,N-di-phényl-amine)-9,9' (Spiro-TAD) d'épaisseur $d_{64}$ = 10 nm, pour le blocage des électrons ;
- et une sous-couche 65 de spiro-bifluorène de 2,2',7,7'-tetrakis(N,N-di-m-méthyl-phényl-amine)-9,9' (Spiro m-TTB) dopée avec un dopant de type p, comme du F4 - TCNQ (tetrafluoro-tetracyano-quino-dimethane) pour l'injection et le transport des trous et d'épaisseur $d_{65}$ déterminée ultérieurement.

Pour former la couche d'électrode supérieure 11 qui sert ici d'anode, on dépose :

- une deuxième sous-couche semi-transparente et conductrice 5, en argent, d'épaisseur $d_5$ = 15 nm environ ; cette sous-couche assure avantageusement une barrière contre la diffusion des atomes des couches supérieures, qui protège la couche organique électroluminescente 6 contre des risques de dégradation.
- une première sous-couche 4 semi-transparente et conductrice, qui est « pleine », c'est à dire sans trous volontairement pratiqués, d'oxyde mixte d'indium et d'étain (ITO), d'épaisseur $d_4$ qui sera précisée ultérieurement ;
- une sous-couche métallique opaque 3 de répartition du courant formée d'un réseau de barreaux métalliques parallèles ménageant entre eux des ouvertures importantes ou fenêtres pour le passage de la lumière émise par la couche électroluminescente 6 ; chaque barreau présente une épaisseur $d_3$, ici égale ou supérieure à 100 nm ; l'épaisseur $d_3$ est établie, selon le métal choisi, pour obtenir une conductivité surfacique au moins 10 fois supérieur e à celle de la sous -couche 4 en ITO, de manière à assurer efficacement la répartition du courant circulant dans l'électrode; le matériau métallique des barreaux présente un indice $\tilde{n}_3$ mesuré à la longueur d'onde $\lambda_{amb}$ correspondant approximativement au maximum de sensibilité spectrale de l'oeil, c'est à dire environ 550 nm.

Sur la couche d'électrode supérieure 11, on dépose ensuite une couche diélectrique transparente 2 d'indice $n_2(\lambda_{amb})$ mesuré à la longueur d'onde $\lambda_{amb}$; cette couche est continue et d'épaisseur homogène $d_2$ ; elle ne présente pas de trous sauf, éventuellement, par suite de défauts. Cette couche, destinée à assurer une fonction anti -reflet, est alors en contact, par sa face interne, avec les barreaux ou zones opaques de la sous -couche métallique 3 de répartition du courant et également avec la sous -couche conductrice transparente 4 au travers des fenêtres situés entre les barreaux de la sous -couche métallique 3.

La nature des matériaux de la première sous-couche conductrice transparente 4 et de la couche diélectrique anti -reflet 2 sont adaptés pour protéger la couche organique sous-jacente 6 contre les risques de dégradation par l'oxygène et/ou par la vapeur d'eau de l'air ambiant: cette sous-couche 4 et/ou cette couche 2 ont donc ici également une fonction d'encapsulation de la diode.

La couche diélectrique transparente 2 est alors en contact, par sa face externe, avec un milieu 1 d'indice $n_1$ mesuré à la longueur d'onde $\lambda_{amb}$; ce matériau est ici de l'air. Selon une première variante non décrite en détail, la diode est encapsulée dans un boîtier étanche remplie d'un gaz ou d'un fluide qui définit alors le milieu 1. Selon une deuxième variante non limitative, une couche supplémentaire d'encapsulation est ajoutée au dessus de la couche diélectrique transparente 2 : le milieu 1 correspond alors au matériau de cette couche d'encapsulation.

L'empilement comprenant, sur le substrat 8, l'au moins une électrode de la couche inférieure 7, la couche organique électroluminescente 6, la couche d'électrode supérieure 11 et la couche anti -reflet 2 forme alors une diode ou un réseau de diodes organiques électroluminescentes selon un mode de réalisation de l'invention dont certains paramètres vont maintenant être précisés.

Selon l'invention, le matériau d'indice $n_2(\lambda_{amb})$ et l'épaisseur $d_2$ de la couche diélectrique 2 sont choisis avec le matériau d'indice $\tilde{n}_3$ de la sous-couche métallique opaque 3 de manière à ce que la réflectance des barreaux de la sous - couche métallique opaque 3, mesurée à $\lambda_{amb}$ (environ 550 nm) en incidence normale, soit inférieure à 0,1. La couche diélectrique 2a alors une fonction anti - reflet vis à vis des barreaux qui forment ici des zones opaques dans l'électrode supérieure transparente : une partie importante de la lumière ambiante n'es t plus réfléchie sur les zones opaques de l'électrode supérieure de la diode, ce qui améliore significativement les performances de contraste d'émission de la diode en lumière ambiante.

On va maintenant décrire, de manière non limitative, une **première façon pour réaliser ce choix.**

La figure 3 illustre, pour une liste de métaux Ta, Cr, Ti, Ni, V susceptibles de former les grilles de la sous-couche 3 de répartition du courant, l'évolution du minimum de réflectivité à $\lambda_{amb}$ d'un métal en fonction de l'indice $n_2$ $(\lambda_{amb})$ du matériau d'une couche diélectrique recouvrant ce métal pour assurer une fonction anti-reflet. Les valeurs $n_2$ $(\lambda_{amb})$ d'indice des diélectriques $SiO_2$, SiN et $TiO_2$ ont été reportés.

Le choix selon l'invention consiste à sélectionner un couple métal - diélectrique pour lequel le minimum de réflectivité est obtenu pour une valeur $n_2^o$ proche de la valeur $n_2$ de l'indice d'un des matériaux diélectrique : on retiendra ainsi :

- avec l'oxyde de titane, le chrome, le titane, le nickel et le vanadium ; parmi ces métaux, on privilégiera le chrome, qui est largement utilisé en micro -électronique ;
- avec le nitrure de silicium, le tantale.

Selon cette méthode, l'utilisation de silice pour la couche diélectrique anti-reflet est à éviter, du moins avec les métaux listés ci-dessus.

On va maintenant décrire, de manière non limitative, une **deuxième façon pour réaliser ce choix.**

Les connaissances générales de l'homme de métier établissent que l'indice $n_2^o(\lambda_{amb})$ que devrait avoir le matériau diélectrique de la couche anti-reflet répond à la relation suivante :

$$n^o{}_2(\lambda_{amb}) = \frac{\sqrt{-(n_1\cos(\phi)-n_3+n_3\sin^2(\phi))n_3\,n_1\,(n_1\sin^2(\phi)+n_3\cos(\phi)-n_1)}}{-(n_1\sin^2(\phi)+n_3\cos(\phi)-n_1)}$$

Le tableau 1 ci-aprés donne l'indice complexe $\tilde{n}_3$ à $\lambda_{amb}$ de différents métaux Cr, Ta, Ti, Ni, V, Co, et la valeur d'indice $n^0{}_2$ à $\lambda_{amb}$ calculés selon cette relation ($n_1$ =1). Dans la partie droite du tableau, figurent des valeurs réelles d'indice de certains matériaux diélectriques SiO$_2$, SiN, TiO$_2$.

Tableau 1

| métal | $\tilde{n}_3$ | $n^0{}_2$ | $d_2$ | | diélectrique | $n_2$ |
|-------|------|------|-------|---|-------------|-------|
| Cr | 2.8 + 3.3 i | 2.97 | 27 nm | | SiO$_2$ | 1,5 |
| Ta | 2.74 + 1.97 i | 2.23 | 39 nm | | SiN | 2,0 |
| Ti | 1.79 + 2.42 i | 3.03 | 20 nm | | TiO$_2$ | 3,0 |
| Ni | 1.69 + 2.99 i | 3.83 | 15 nm | | | |
| V | 3.59 + 3.21 i | 2.75 | 33 nm | | | |
| Co | 2.02 + 3.72 i | 3.95 | 17 nm | | | |

Le choix selon l'invention consiste à sélectionner un couple métal - diélectrique pour lequel les valeurs correspondantes de $n^0{}_2$ et de $n_2$ sont aussi proches que possible l'une de l'autre; on retiendra ainsi:

- avec l'oxyde de titane, le chrome, le titane, le cobalt ou le vanadium; parmi ces métaux, on privilégiera le chrome, qui est largement utilisé en micro -électronique;
- avec le nitrure de silicium, le tantale.

Selon cette méthode, l'utilisation de silice pour la couche diélectrique anti - reflet est à éviter, du moins avec les métaux listés ci -dessus.

**Pour la suite de la description, on retiendra le couple Cr -TiO$_2$.**

Le matériau (chrome) de la grille formant la sous -couche conductrice opaque 3 traversée par des fenêtres et celui (oxyde de titane) de la couche diélectrique anti-reflet 2 étant choisis, reste à déterminer notamment l'épaisseur idéale $d_2$ de cette couche diélectrique.

De préférence, si $\Phi_{2\text{-}3}$ est le déphasage d'un rayon de lumière de longueur d'onde $\lambda_{amb}$ après réflexion à l'interface entre la couche diélectrique 2 et les barreaux de la sous-couche métallique 3, on choisit l'épaisseur $d_2$ de manière a satisfaire approximativement l'équation :

$$d_2 = \frac{\lambda_{amb}}{4n_2}\left(p - \frac{\Phi_{2\text{-}3}}{\pi}\right)$$

où p est un entier pair quelconque, et où $\lambda_{amb}$ est une longueur d'onde proche du maximum d'émittance de la lumière ambiante, généralement de l'ordre de 550 nm. L'équation donnant ainsi la valeur de $d_2$ exprime des interférences destructrices de la lumière ambiante au sein de la couche diélectrique anti -reflet, au dessus des zones opaques de la couche métallique 3 de répartition du courant.

Comme l'indique le tableau 1, on aboutit alors à $d_2$ = 27 nm (pour p = 0). Le tableau indique également les valeurs de $d_2$ (toujours pour p = 0) qu'on obtiendrait en utilisant l'oxyde de titane sur d'autres métaux ; les variations de d2 reflète les valeurs de $\Phi_{2\text{-}3}$ propres à chaque métal.

Dans la diode selon l'invention, entre les zones opaques de l'électrode supérieure (c'est à dire entre les barreaux de la grille), la couche organique 6 est revêtue d'un empilement de trois sous-couches qui forment une couche supérieure semi-réfléchissante : la deuxième sous-couche conductrice et semi-transparente 5 d'épaisseur $d_5$ = 15 nm et en argent, la première sous-couche conductrice et semi-transparente 4 d'épaisseur $d_4$ et en ITO et, entre les barreaux d'épaisseur $d_3 > 100$ nm de la couche métallique 3 de répartition du courant, la couche diélectrique 2 d'épaisseur $d_2 = 27$ nm et en oxyde de titane. Selon l'invention, l'épaisseur $d_4$ de la sous-couche conductrice transparente 4 de l'électrode supérieure est choisie de manière à obtenir approximativement un maximum de réflectance de cet empilement des trois sous-couches pour la lumière émise par la couche électroluminescente. Cette réflectance est évaluée ici à la longueur d'onde $\lambda$, précédemment définie, pour laquelle l'émittance de la sous - couche émissive 61 présente un maximum. La couche diélectrique 2 apporte donc une double fonction : fonction anti-reflet pour la lumière ambiante précédemment décrite, et fonction d'amélioration des propriétés réfléchissantes de la couche supérieure semi-réfléchissante pour la lumière émise par la couche électroluminescente.

Par ailleurs, à l'endroit des barreaux d'épaisseur de la couche métallique 3 de répartition du courant, c'est la surface inférieure du barreau qui assure avantageusement la fonction réfléchissante de la lumière émise par la couche électroluminescente ; on voit que la couche métallique 3 de répartition du courant apporte également une double fonction : fonction de distribution du courant et fonction de réflexion de la lumière émise par la couche électroluminescente.

L'électrode supérieure forme donc, en combinaison avec la couche diélectrique 2, une surface semi -réfléchissante, qui renvoie la lumière émise vers l'intérieur de la diode. On obtient donc entre les deux électrodes, inférieure réfléchissante et supérieure semi -réfléchissante, une cavité optique pour la lumière émise à la longueur d'onde $\lambda$, dans la couche électroluminescent e.

Grâce au maximum de réflectance de l'électrode supérieure avec la couche diélectrique 2 qu'on obtient comme précédemment décrit, on augmente cet effet de cavité optique, ce qui permet d'améliorer l'extraction de la lumière émise et le rendement lumineux de la diode.

On va maintenant décrire, de manière non limitative, **une méthode pour réaliser le choix d'épaisseur $d_4$** de la première sous-couche conductrice 4 en ITO. La figure 4 représente la variation de la réflectance de l'empilement précédemment décrit en fonction de cette épaisseur $d_4$. Cette figure comprend trois courbes, l'une R pour une longueur d'onde dans le rouge utilisable pour des diodes émettant dans le rouge, une seconde G pour une longueur d'onde dans le vert utilisable pour des diodes émettant dans le vert, la dernière B pour une longueur d'onde dans le bleu utilisable pour des diodes émettant dans le bleu. On choisit sur cette figure une valeur de $d_4$ correspondant au maximum de réflectance. Le tableau 2 ci-après indique les valeurs de $d_4$ ainsi choisies : 60 nm pour le rouge, 40 nm pour le vert et 30 nm pour le bleu.

On va maintenant établir les relations définissant l'épaisseur total $d_6$ de la couche organique électroluminescente et la distance z séparant approximativement le centre de la sous-couche organique émissive 61 de l'électrode inférieure réfléchissante 7 qui permettent à l'effet de cavité optique obtenu entre les deux électrodes d'améliorer sensiblement le rendement d'extraction de lumière émise par la diode :

En premier lieu, on choisit approximativement $d_6$ tel que:

$$d_6 = \frac{\lambda}{2n_6}\left(q - \frac{\phi_{tot}}{2\pi}\right)$$

- où q est un entier quelconque,
- où $\lambda$ est toujours approximativement la longueur d'onde de maximum d'émission de la diode,
- $n_6$ est l'indice moyen de la couche organique électroluminescente 6 à cette longueur d'onde,
- et où $\phi_{tot}$ est le déphasage total d'un rayon de lumière émise, après réflexion par l'électrode inférieure réfléchissante 7 et par l'empilement précédemment décrit des trois couches ou sous-couches supérieures 5, 4, 2.

L'équation fixant la valeur approximative de $d_6$ exprime des interférences constructives de la lumière émise dans la cavité optique entre l'électrode inférieure 7 et l'empilement supérieur semi -réfléchissant 5, 4, 2.

En deuxième lieu, on choisit approximativement l'épaisseur de la sous - couche 62 d'injection et/ou de transport de trous de manière à ce que la distance z soit approximativement égale à :

$$z = \frac{\lambda}{2n_6}\left(r - \frac{\phi_{inf}}{2\pi}\right)$$

- r est un entier quelconque;
- où $n_6$ est l'indice moyen des sous -couches de la couche organique électroluminescente à la longueur d'onde $\lambda$; ici, $n_6 = 1,7$ ;

- où $\phi_{int}$ est le déphasage d'un rayon de lumière émise, après réflexion par l'électrode inférieure réfléchissante; ici, $\Phi_{int}$ = 2,6 rd;

L'équation fixant la valeur approximative de z exprime des interférences constructives entre la lumière émise dans la sous-couche émissive 61 et la lumière réfléchie sur l'électrode inférieure réfléchissante 7.

Les deux types d'interférences ci-dessus coopèrent avantageusement à l'obtention d'un taux d'extraction de lumière très élevé, ce qui améliore le rendement lumineux de la diode.

Un moyen équivalent pour établir la valeur de $d_6$ qui permet d'obtenir des interférences constructives dans la cavité optique consiste à extraire cette donnée d'une des courbes de la figure 5, qui, à l'aide d'un modèle numérique simple à la portée de l'homme du métier ou de diodes présentant différentes caractéristiques géométriques, donne les variations de l'intensité lumineuse sortant effectivement de la diode (lumière extraite - unités arbitraires) en fonction de la valeur de $d_6$ (nm): on choisit la valeur de $d_6$ qui donne approximativement le maximum d'intensité lumineuse. Ces valeurs de $d_6$ sont reportées sur le tableau 2 ci-après pour les couleurs d'émission rouge, verte, et bleue.

Comme on a :

- $z = d_{61}/2 + d_{62} + d_{63}$, approximativement : comme on connaît déjà $d_{61}$ = 20 nm et $d_{63}$ = 10 nm, on en déduit alors $d_{62}$.
- $d_6 = d_{61} + d_{62} + d_{63} + d_{64} + d_{65} = z + d_{61}/2 + d_{64} + d_{65}$.: comme on connaît déjà $d_{61}$ = 20 nm et $d_{64}$ = 10 nm, on en déduit alors $d_{65}$.

L'ensemble des valeurs obtenues est récapitulée au tableau 2 pour chaque couleur, rouge, verte et bleue :

L' abréviation « Int » dans la dernière colonne désigne l'intensité lumineuse extraite en unité arbitraire.

On obtient une diode électroluminescente ou un réseau de diodes électroluminescente à émission vers le haut, présentant un excellent rendement lumineux grâce à la combinaison des caract éristiques spécifiques à l'invention qui viennent d'être décrites.

Tableau 2

| Couleur | $\lambda$ | ITO $d_4$ Réf 4 | z | EIL/ ETL $d_{62}$ | HBL $d_{63}$ | EML $d_{61}$ | EBL $d_{64}$ | HIL/ HTL $d_{65}$ | Tot. d6 | Int. |
|---|---|---|---|---|---|---|---|---|---|---|
| | nm | nm | nm | nm | nm | nm | nm | nm | nm | a.u. |
| Bleu | 452 | 30 | 53 | 23 | 10 | 20 | 10 | 37 | 100 | 6.7 |
| Vert | 516 | 40 | 61 | 31 | 10 | 20 | 10 | 44 | 115 | 6.7 |
| Rouge | 636 | 60 | 75 | 45 | 10 | 20 | 10 | 55 | 140 | 6.0 |

On va maintenant décrire un **deuxième mode de réalisation de l'invention** , qui est une variante du premier mode précédemment décrit, dans lequel la seule différence est que la première sous-couche conductrice transparente 4 est en oxyde de titane au lieu d'être en ITO.

A l'aide de la figure 6 en remplacement de la figure 4, de la figure 7 en remplacement de la figure 5, on établit d'une manière analogue à celle précédemment décrites les nouveaux résultats reportés au tableau 3 :

Tableau 3

| Couleur | $\lambda$ | TiO$_2$ $d_4$ Réf 4 | z | EIL/ ETL Réf.62 | HBL Réf.63 | EML Réf.61 | EBL Réf.64 | HIL/ HTL Réf.65 | Tot. d6 | Int. |
|---|---|---|---|---|---|---|---|---|---|---|
| | nm | nm | nm | nm | nm | nm | nm | nm | nm | a.u. |
| Bleu | 452 | 20 | 53 | 23 | 10 | 20 | 10 | 42 | 105 | 7,1 |
| Vert | 516 | 36 | 61 | 31 | 10 | 20 | 10 | 49 | 120 | 7,0 |
| Rouge | 636 | 38 | 75 | 45 | 10 | 20 | 10 | 65 | 150 | 6,8 |

La présente invention s'applique également à une diode ou un panneau organique électroluminescent où l'injection des charges se fait par des couches organiques dopées ; il est évident pour l'homme du l'art qu'elle peut s'appliquer à d'autres types de diodes, de panneaux d'éclairage ou d'affichage sans sortir du cadre des revendications ci -après.

**Revendications**

**1.** Diode organique électroluminescente susceptible d'émettre de la lumière, comprenant :

- un substrat (8),
- une couche organique électroluminescente (6) susceptible d'émettre de la lumière, intercalée entre une électrode inférieure et une électrode supérieure partiellement transparente, qui sont adaptées pour faire passer un courant au travers de la couche organique électroluminescente (6) et provoquer ainsi une émission de lumière au sein de cette couche,
ladite électrode supérieure comprenant au moins une sous-couche conductrice transparente ou semi-transparente (4, 5) d'épaisseur approximativement homogène et une sous-couche métallique (3) de répartition du courant qui se répartit en zones opaques entre lesquelles des épargnes dans cette sous-couche forment des fenêtres pour le passage de la lumière émise par la couche électroluminescente (6),
- une couche inférieure réfléchissante adaptée pour réfléchir ladite lumière émise, qui est intercalée entre ledit substrat et ladite couche organique électroluminescente (6) ou qui est intégrée au substrat,
- et une couche diélectrique transparente anti-reflet (2) d'épaisseur approximativement homogène, en contact, par sa face externe, avec un milieu (1), comme par exemple de l'air, et, par sa face interne, avec une dite sous-couche conductrice transparente (4) et ladite sous-couche métallique opaque (3),

où le matériau et l'épaisseur de ladite couche diélectrique anti-reflet (2) sont choisis avec le matériau de ladite sous-couche métallique (3) de répartition du courant de manière à ce que la réflectance, mesurée à l'endroit desdites zones opaques, en incidence normale, et à une longueur d'onde $\lambda_{amb}$ proche de 550 nm, soit inférieure à 0,1 ; **caractérisée en ce que**, si $\lambda$ est une longueur d'onde proche d'un maximum d'émittance de la lumière émise, le matériau, l'indice ($n_2$) mesuré à la longueur d'onde $\lambda$ et l'épaisseur ($d_2$) de ladite couche diélectrique anti-reflet (2) sont choisis avec le matériau, l'indice ($n_4$, $n_5$) mesuré à la longueur d'onde $\lambda$ et l'épaisseur ($d_4$, $d_5$) de l'au moins une sous-couche conductrice transparente ou semi-transparente (4, 5) de manière à composer une couche supérieure semi-réfléchissante adaptée pour réfléchir partiellement ladite lumière émise dont la réflectance, mesurée à cette longueur d'onde $\lambda$ en incidence normale, soit maximum,
la couche inférieure réfléchissante et la couche supérieure semi-réfléchissante ainsi composée délimitant une cavité optique pour la lumière émise par la couche organique électroluminescente.

**2.** Diode selon la revendication 1 **caractérisée en ce que** la distance $d_6$ entre les couches délimitant ladite cavité est adaptée pour obtenir des interférences constructives de la lumière émise au sein de cette cavité et satisfait approximativement la relation suivante :

$$d_6 = \frac{\lambda}{2n_6}\left(q - \frac{\phi_{tot}}{2\pi}\right)$$

- où q est un entier quelconque,
- où et $n_6$ est l'indice moyen de la couche organique électroluminescente à cette longueur d'onde $\lambda$,
- et où $\phi_{tot}$ est le déphasage total d'un rayon de lumière émise, après réflexion par la couche inférieure réfléchissante et par la couche supérieure semi-réfléchissante.

**3.** Diode selon la revendication 1 ou 2 **caractérisée en ce que**, si $n_1$ est l'indice optique dudit milieu (1) à la longueur d'onde $\lambda_{amb}$, le matériau d'indice $n_2(\lambda_{amb})$ mesuré à la longueur d'onde $\lambda_{amb}$, et l'épaisseur $d_2$ de ladite couche diélectrique anti-reflet (2) sont choisis avec le matériau d'indice $\tilde{n}_3$ de ladite sous-couche métallique (3) de répartition du courant, qui est mesuré à la même longueur d'onde $\lambda_{amb}$ et qui est défini par son argument $n_3$ et sa phase $\Phi$ de sorte que $\tilde{n}_3 = n_3 e^{i\Phi}$, de manière à satisfaire approximativement la relation:

$$n_2(\lambda_{amb}) = \frac{\sqrt{-(n_1\cos(\phi) - n_3 + n_3\sin^2(\phi))n_3 n_1(n_1\sin^2(\phi) + n_3\cos(\phi) - n_1)}}{-(n_1\sin^2(\phi) + n_3\cos(\phi) - n_1)}$$

**4.** Diode selon l'une quelconque des revendications précédentes, **caractérisée en ce que**, le matériau d'indice $n_2$

($\lambda_{amb}$) mesuré à une longueur d'onde $\lambda_{amb}$ proche de 550 nm, et l'épaisseur $d_2$ de ladite couche diélectrique anti-reflet (2) sont choisis de manière à satisfaire approximativement la relation :

$$d_2 = \frac{\lambda_{amb}}{4n_2(\lambda_{amb})}\left(p - \frac{\phi_{2-3}}{\pi}\right)$$

où p est un entier pair quelconque, où $\Phi_{2-3}$ est le déphasage d'un rayon de lumière de longueur d'onde $\lambda_{amb}$ après réflexion à l'interface entre la couche diélectrique anti-reflet (2) et la sous-couche métallique (3) de répartition du courant.

5. Diode selon l'une quelconque des revendications précédentes **caractérisée en ce que** le matériau de ladite couche diélectrique anti-reflet (2) et le matériau de ladite sous-couche métallique (3) de répartition du courant, sont respectivement :

  - soit le nitrure de silicium et le tantale,
  - soit l'oxyde de titane et l'un parmi le nickel, le chrome, le titane ou le vanadium.
  - soit le séléniure de zinc et l'un parmi le nickel, le chrome, le titane ou le vanadium.

6. Diode selon l'une quelconque des revendications précédentes, **caractérisée en ce que** la distance séparant la couche organique électroluminescente de la couche inférieure réfléchissante est adaptée pour obtenir des interférences constructives entre ladite lumière émise et la lumière réfléchie sur cette couche inférieure réfléchissante, et **en ce que** ladite couche organique électroluminescente (6) comprend une sous-couche organique émissive et au moins une sous-couche organique inférieure non-émissive qui est intercalée entre ladite couche inférieure réfléchissante et ladite sous-couche émissive, et **en ce que** l'épaisseur de la ou des sous-couches organiques inférieures non-émissives est/sont adaptée(s) pour que la distance z séparant le centre de ladite sous-couche organique émissive de ladite couche inférieure réfléchissante satisfasse approximativement la relation:

$$z = \frac{\lambda}{2n_6}\left(r - \frac{\phi_{inf}}{2\pi}\right)$$

  - où r est un entier quelconque ;
  - où $\lambda$ est ladite longueur d'onde $\lambda$ proche d'un maximum d'émittance de la lumière émise, et $n_6$ est l'indice moyen de la couche organique électroluminescente à cette longueur d'onde,
  - où $\phi_{int}$ est le déphasage d'un rayon de lumière émise, après réflexion par la couche inférieure réfléchissante.

7. Panneau de visualisation d'images ou d'éclairage comprenant une pluralité de diodes selon l'une quelconque des revendications précédentes **caractérisé en ce que** ces diodes sont supportées par le même substrat.

8. Panneau selon la revendication 7 **caractérisé en ce que** ladite électrode supérieure est commune à la pluralité desdites diodes.

9. Panneau selon la revendication 8 **caractérisé en ce que** ladite sous-couche conductrice opaque de l'électrode supérieure commune forme une grille de répartition du courant sur cette électrode.

**Claims**

1. An organic light-emitting diode capable of emitting light, comprising:

  - a substrate (8);
  - an organic electroluminescent layer (6) capable of emitting light, interposed between a lower electrode and a partially transparent upper electrode, which are designed to pass a current through the organic electroluminescent layer (6) and thus cause, within this layer, the emission of light,
  said upper electrode comprising at least one transparent or semitransparent conducting sublayer (4, 5) of approximately uniform thickness and a metal sublayer (3) for distributing the current, which is distributed in opaque zones between which there are gaps in this sublayer that form windows for passage of the light emitted by the electroluminescent layer (6);

- a reflective lower layer designed to reflect said emitted light, which layer is interposed between said substrate and said organic electroluminescent layer (6) or is integrated into the substrate; and

- and a transparent dielectric antireflection layer (2) of approximately uniform thickness in contact, via its external face, with a medium (1), such as for example air, and, via its internal face, with a said transparent conducting sublayer (4) and said opaque metal sublayer (3),

wherein the material and the thickness of said dielectric antireflection layer (2) are chosen with the material of said current-distributing metal sublayer (3) so that the reflectance, measured at the places of said opaque zones, at normal incidence, and at a wavelength $\lambda_{amb}$ close to 550 nm, is less than 0.1; **characterized in that**, if $\lambda$ is a wavelength close to the maximum of emittance for the emitted light, the material, the index ($n_2$) measured at the wavelength $\lambda$ and the thickness ($d_2$) of said dielectric antireflection layer (2) are chosen with the material, the index ($n_4$, $n_5$) measured at the wavelength $\lambda$ and the thickness ($d_4$, $d_5$) of the at least one transparent or semitransparent conducting sublayer (4, 5) so as to make up a semireflective upper layer designed to partially reflect said emitted light, the reflectance of which being maximum, said reflectance being measured at this wavelength $\lambda$ at normal incidence.

the reflective lower layer and the semireflective upper layer made up this way thus defining an optical cavity for the light emitted by the organic electroluminescent layer.

2. The diode as claimed in claim 1 **characterized in that** the distance $d_6$ between the layers delimiting said cavity is adapted so as to obtain constructive interference of the light emitted within said cavity and approximately satisfies the following equation:

$$d_6 = \frac{\lambda}{2n_6}\left(q - \frac{\phi_{tot}}{2\pi}\right)$$

- where q is any integer;
- where $n_6$ is the average index of the organic electroluminescent layer at this wavelength $\lambda$; and
- where $\Phi_{tot}$ is the total phase shift of a ray of emitted light, after reflection off the reflective lower layer and off the semireflective upper layer.

3. The diode as claimed in claim 1 or 2, **characterized in that**, if $n_1$ is the optical index of said medium (1) at the wavelength $\lambda_{amb}$, the material of index $n_2$ ($\lambda_{amb}$) measured at the wavelength $\lambda_{amb}$, and the thickness $d_2$ of said dielectric antireflection layer (2) are chosen with the material of index $\tilde{n}_3$ of said current-distributing metal sublayer (3), which is measured at the same wavelength $\lambda_{amb}$ and is defined by its argument $n_3$ and its phase $\Phi$ in such a way that $\tilde{n}_3 = n_3 e^{i\Phi}$, so as to approximately satisfy the equation:

$$n_2(\lambda_{amb}) = \frac{\sqrt{-(n_1\cos(\phi) - n_3 + n_3\sin^2(\phi))n_3 n_1(n_1\sin^2(\phi) + n_3\cos(\phi) - n_1)}}{-(n_1\sin^2(\phi) + n_3\cos(\phi) - n_1)}$$

4. The diode as claimed in any one of the preceding claims, **characterized in that** the material of index $n_2(\lambda_{amb})$ measured at a wavelength $\lambda_{amb}$ close to 550 nm, and the thickness $d_2$ of said dielectric antireflection layer (2) are chosen so as to approximately satisfy the equation:

$$d_2 = \frac{\lambda_{amb}}{4n_2(\lambda_{amb})}\left(p - \frac{\phi_{2-3}}{\pi}\right)$$

where p is any even integer and where $\Phi_{2\text{-}3}$ is the phase shift of a light ray of wavelength $\lambda_{amb}$ after reflection at the interface between the dielectric antireflection layer (2) and the current-distributing metal sublayer (3).

**5.** The diode as claimed in any one of the preceding claims, **characterized in that** the material of said dielectric antireflection layer (2) and the material of said current-distributing metal sublayer (3) are, respectively:

- either silicon nitride and tantalum;
- or titanium oxide and a metal from among nickel, chromium, titanium and vanadium;
- or zinc selenide and a metal from among nickel, chromium, titanium and vanadium.

**6.** The diode as claimed in any one of the preceding claims, **characterized in that** the distance separating the organic electroluminescent layer from the reflective lower layer is adapted so as to obtain constructive interference between said emitted light and the light reflected off this reflective lower layer and **in that** said organic electroluminescent layer (6) comprises an emissive organic sublayer and at least one nonemissive lower organic sublayer that is interposed between said reflective lower layer and said emissive sublayer, and **in that** the thickness of the nonemissive lower organic sublayer(s) is (are) adapted so that the distance z separating the center of said emissive organic sublayer of said reflective lower layer approximately satisfies the equation:

$$z = \frac{\lambda}{2n_6}\left(r - \frac{\phi_{inf}}{2\pi}\right)$$

- where r is any integer;
- where $\lambda$ is said wavelength close to the maximum of emittance for the emitted light and $n_6$ is the average index of the organic electroluminescent layer at this wavelength; and
- where $\Phi_{inf}$ is the phase shift of a ray of emitted light after reflection off the reflective lower layer.

**7.** An image display or illumination panel comprising a plurality of diodes as claimed in any one of the preceding claims, **characterized in that** these diodes are supported by the same substrate.

**8.** The panel as claimed in claim 7, **characterized in that** said upper electrode is common to the plurality of said diodes.

**9.** The panel as claimed in claim 8, **characterized in that** said opaque conducting sublayer of the common upper electrode forms a current-distributing grid on this electrode.

**Patentansprüche**

**1.** Organische Elektrolumineszenzdiode, die Licht emittieren kann, mit

- einem Substrat (8),
- einer organischen Elektrolumineszenzschicht (6), die Licht emittieren kann und zwischen einer unteren Elektrode und einer oberen, teilweise durchsichtigen Elektrode angeordnet ist, welche Elektroden geeignet sind, einen Strom durch die organische Elektrolumineszenzschicht (6) fließen zu lassen und somit eine Lichtemission in dieser Schicht zu bewirken,
wobei die obere Elektrode mindestens eine leitfähige durchsichtige oder halbdurchsichtige Unterschicht (4, 5) mit einer annähernd homogenen Dicke und eine metallische Unterschicht (3) für die Stromverteilung umfasst, welche sich in undurchsichtige Bereiche aufteilt, zwischen denen Aussparungen in dieser Unterschicht Fenster für den Durchtritt des von der Elektrolumineszenzschicht (6) emittierten Lichts bilden,
- einer unteren reflektierenden Schicht, die geeignet ist, das emittierte Licht zu reflektieren, zwischen dem Substrat und der organischen Elektrolumineszenzschicht (6) angeordnet ist oder in das Substrat integriert ist, und
- einer dielektrischen durchsichtigen Antireflexschicht (2) mit einer annähernd homogenen Dicke, welche an ihrer Außenfläche mit einer Umgebung (1), beispielsweise Luft, und an ihrer Innenfläche mit einer leitfähigen durchsichtigen Unterschicht (4) und der undurchsichtigen metallischen Unterschicht (3) in Kontakt steht,

wobei das Material und die Dicke der dielektrischen Antireflexschicht (2) mit dem Material der metallischen Unterschicht (3) für die Stromverteilung derart gewählt sind, dass der an der Stelle der undurchsichtigen Bereiche bei normalem Einfall und bei einer Wellenlänge $\lambda_{amb}$ nahe 550 nm gemessene Reflexionskoeffizient geringer als 0,1 ist, **dadurch gekennzeichnet, dass**, wenn $\lambda$ eine Wellenlänge ist, die einem Maximum des Emissionsvermögens des emittierten Lichts nahe kommt, das Material, der bei der Wellenlänge $\lambda$ gemessene Index ($n_2$) und die Dicke ($d_2$) der dielektrischen Antireflexschicht (2) mit dem Material, dem bei der Wellenlänge $\lambda$ gemessenen Index ($n_4$, $n_5$) und der Dicke ($d_4$, $d_5$) der mindestens einen leitfähigen durchsichtigen oder halbdurchsichtigen Unterschicht (4, 5) gewählt werden, um eine obere halbreflektierende Schicht zu bilden, die geeignet ist, das emittierte Licht teilweise zu reflektieren, dessen bei normalem Einfall bei dieser Wellenlänge $\lambda$ gemessener Reflexionskoeffizient maximal ist, die reflektierende untere Schicht und die derart gebildete halbreflektierende obere Schicht einen optischen Hohlraum für das von der organischen Elektrolumineszenzschicht emittierte Licht begrenzen.

2. Diode nach Anspruch 1, **dadurch gekennzeichnet, dass** der Abstand d6 zwischen den den Hohlraum begrenzenden Schichten geeignet ist, konstruktive Interferenzen des emittierten Lichts in diesem Hohlraum zu erzielen, und die folgende Beziehung annähernd erfüllt:

$$d_6 = \frac{\lambda}{2n_6}\left(q - \frac{\phi_{tot}}{2\pi}\right)$$

- wobei q eine beliebige Ganzzahl ist,
- wobei $n_6$ der mittlere Index der organischen Elektrolumineszenzschicht bei dieser Wellenlänge $\lambda$ ist, und
- wobei $\phi_{tot}$ die totale Phasenverschiebung eines Strahls des emittierten Lichts nach Reflexion durch die untere reflektierende Schicht und durch die obere halbreflektierende Schicht ist.

3. Diode nach Anspruch 1 oder 2, **dadurch gekennzeichnet, dass**, wenn $n_1$ der optische Index der Umgebung (1) bei der Wellenlänge $\lambda_{amb}$ ist, das Material mit dem bei der Wellenlänge $\lambda_{amb}$ gemessenen Index $n_2$ ($\lambda_{amb}$) und die Dicke $d_2$ der dielektrischen Antireflexschicht (2) mit dem Material mit dem Index $\tilde{n}_3$ der metallischen Unterschicht (3) für die Stromverteilung, der bei der gleichen Wellenlänge $\lambda_{amb}$ gemessen wird und durch sein Argument $n_3$ und seine Phase $\phi$ derart definiert ist, dass $\tilde{n}_3 = n_3 e^{i\Phi}$, gewählt werden, um die Beziehung

$$n_3(\lambda_{amb}) = \frac{\sqrt{-(n_1\cos(\phi) - n_3 + n_3\sin^2(\phi))n_3 n_1(n_1\sin^2(\phi) + n_3\cos(\phi) - n_1)}}{-(n_1\sin^2(\phi) + n_3\cos(\phi) - n_1)}$$

annähernd zu erfüllen.

4. Diode nach einem beliebigen der vorhergehenden Ansprüche, **dadurch gekennzeichnet, dass** das Material mit dem bei einer Wellenlänge $\lambda_{amb}$ nahe 550 nm gemessenen Index $n_2$ ($\lambda_{amb}$) und die Dicke $d_2$ der dielektrischen Antireflexschicht (2) gewählt werden, um die folgende Beziehung annähernd zu erfüllen:

$$d_2 = \frac{\lambda_{amb}}{4n_2(\lambda_{amb})}\left(p - \frac{\phi_{2\text{-}3}}{\pi}\right)$$

wobei p eine beliebige gerade Ganzzahl ist, wobei $\phi_{2\text{-}3}$ die Phasenverschiebung eines Lichtstrahls mit der Wellenlänge $\lambda_{amb}$ nach Reflexion an der Schnittstelle zwischen der dielektrischen Antireflexschicht (2) und der metallischen Unterschicht (3) für die Stromverteilung ist.

5. Diode nach einem beliebigen der vorhergehenden Ansprüche, **dadurch gekennzeichnet, dass** es sich bei dem Material der dielektrischen Antireflexschicht (2) und bei dem Material der metallischen Unterschicht (3) für die Stromverteilung jeweils um

- Siliziumnitrid und Tantal oder
- Titanoxid und entweder Nickel oder Chrom oder Titan oder Vanadium,
- Zinkselenid und entweder Nickel oder Chrom oder Titan oder Vanadium

handelt.

**6.** Diode nach einem beliebigen der vorhergehenden Ansprüche, **dadurch gekennzeichnet, dass** der Abstand zwischen der organischen Elektrolumineszenzschicht und der unteren reflektierenden Schicht geeignet ist, konstruktive Interferenzen zwischen dem emittierten Licht und dem auf dieser unteren reflektierenden Schicht reflektierten Licht zu erzielen, und dass die organische Elektrolumineszenzschicht (6) eine organische Emissionsunterschicht und mindestens eine organische untere nicht emittierende Unterschicht umfasst, die zwischen der unteren reflektierenden Schicht und der Emissionsunterschicht angeordnet ist, und dass die Dicke der organischen unteren nicht emittierenden Unterschicht(en) geeignet ist, damit der Abstand z zwischen dem Zentrum der organischen Emissionsunterschicht der unteren reflektierenden Schicht folgende Beziehung annähernd erfüllt:

$$ z = \frac{\lambda}{2n_6} \left( r - \frac{\phi_{int}}{2\pi} \right) $$

- wobei r eine beliebige Ganzzahl ist,
- wobei $\lambda$ die Wellenlänge $\lambda$ ist, die einem Maximum des Emissionsvermögens des emittierten Lichts nahe kommt, und $n_6$ der mittlere Index der organischen Elektrolumineszenzschicht bei dieser Wellenlänge ist, und
- wobei $\phi_{int}$ die Phasenverschiebung eines Strahls des emittierten Lichts nach Reflexion durch die untere reflektierende Schicht ist.

**7.** Bildanzeige- bzw. Beleuchtungsschirm mit einer Vielzahl von Dioden nach einem der vorhergehenden Ansprüche, **dadurch gekennzeichnet, dass** diese Dioden von einem selben Substrat getragen werden.

**8.** Bildanzeige- bzw. Beleuchtungsschirm nach Anspruch 7,
**dadurch gekennzeichnet, dass** die obere Elektrode der Diodenvielzahl gemeinsam ist.

**9.** Bildanzeige- bzw. Beleuchtungsschirm nach Anspruch 8,
**dadurch gekennzeichnet, dass** die leitfähige undurchsichtige Unterschicht der oberen gemeinsamen Elektrode ein Gitter für die Stromverteilung auf dieser Elektrode bildet.

**2** $(n_2, d_2)$

**1** : air $(n_1)$

**3** $(n_3, d_3)$

**5** $(n_5, d_5)$

$d_3$

**12**

**4** $(n_4, d_4)$

**11**

**10**

**6** $(n_6, d_6)$

$d_6$

**7** $(n_7)$

**8**

Fig.1

**11**

**61**

**10**

**63**

**65**

**64**

**6** $(n_6, d_6)$

**62**

**Z**

$d_6$

**7**

**8**

Fig.2

Fig.3

Fig.4

Fig.5

Fig.6

Fig.7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040178722 A
- US 2003184982 A

- WO 03052842 A

**Littérature non-brevet citée dans la description**

- **Yang et al.** High contrast top emitting OLEDs for OLED displays. *Lasers and Electo-optics society, 2004, the 17th annual meeting of the IEEE Rio Grande,* 08 Novembre 2004, vol. 1 (8-9), 186-187